# EUROPEAN PATENT APPLICATION

(11) **EP 4 492 451 A1**
(43) Date of publication of application: **15.01.2025**
(21) Application number: 23844352.7
(22) Date of filing: 26.09.2023
(51) Int. Cl.: H01L 23/31, H01L 25/16, H01L 25/065, H01L 23/00, H01L 25/00, H01L 21/683, H01L 23/538

(54) **CHIP ASSEMBLY, CHIP ADAPTER BOARD, AND PREPARATION METHOD FOR CHIP ASSEMBLY**

(30) Priority: 29.05.2023 CN 202310620957
(71) Applicant: Hygon Information Technology Co., Ltd., Tianjin 300392 (CN)
(72) Inventor: XUE, Xiaodi, Tianjin 300392 (CN)
(74) Representative: Regimbeau
(86) International application number: PCT/CN2023/121378
(87) International publication number: WO 2024/244237

(57) **Abstract**

The present disclosure provides a chip assembly, a chip interposer and a fabricating method for the chip assembly, the chip assembly includes: a first chip, a second chip, and a chip interposer connected with the first chip and the second chip, respectively; the chip interposer includes a wiring structure configured to be connected to an external wiring, and the wiring structure is connected with the first chip and the second chip, respectively. The embodiments of the present disclosure can reduce a voltage drop generated in the chip assembly while improving a bandwidth of interaction between different chips in the chip assembly.

## Description

### CROSS-REFERENCE OF RELATED APPLICATION

The present application claims the priority of Chinese Patent Application No.202310620957.5 filed on May 29, 2023, and the disclosure of the above-mentioned Chinese Patent Application is incorporated herein by reference as a part of the present application.

### TECHNICAL FIELD

Embodiments of the present disclosure relate to a chip assembly, a chip interposer and a fabricating method for the chip assembly.

### BACKGROUND

Three-dimensional (3D) packaging technology for chips refers to the packaging technology of packaging two or more chips connected with each other in a single package. In recent years, as key technology supporting the 3D packaging, the Through Silicon Via (TSV) technology has gained continuous breakthroughs, and the 3D packaging technology with the TSV as the core has become an important development direction of the new generation packaging technology which is generally acknowledged in the industry.

### SUMMARY

The present disclosure provides a chip assembly, a chip interposer and a fabricating method for the chip assembly, which can reduce a voltage drop generated in the chip assembly while improving a bandwidth of interaction between different chips in the chip assembly.

In a first aspect, the present disclosure provides a chip assembly, including: a first chip, a second chip, and a chip interposer, connected with the first chip and the second chip, respectively; the chip interposer includes a wiring structure configured to be connected to an external wiring, and the wiring structure is connected with the first chip and the second chip, respectively.

In the chip assembly provided by the embodiment of the present disclosure, the wiring structure is disposed to be respectively connected with the first chip and the second chip, and at the same time, since an external wiring is connected with the wiring structure, the external wiring can directly supply power to the first chip and the second chip through the wiring structure when supplying power to the chips, so that a small voltage drop is generated on a path of power supply, thereby reducing the voltage drop in the chip assembly; moreover, both the first chip and the second chip are connected with the wiring structure, and the first chip and the second chip can be in communication with each other through the wiring structure, so that a bandwidth of signal-interactive communication among different chips in the chip assembly is increased.

In an optional embodiment, the chip interposer further includes a body part having a cavity, and the body part includes an opening which is connected with the cavity and penetrates through a surface of the body part; the wiring structure includes a wiring layer and a plurality of bonding parts connected with the wiring layer; the wiring layer is disposed in the cavity, and the plurality of bonding parts are exposed from the surface of the body part through the opening. The bonding parts are exposed from the surface of the body part by the opening, and can be used to bond with other structures, which can increase the electrical performance of the wiring structure after being connected to other structures.

In an optional embodiment, the wiring layer includes a plurality of first-type wirings and a plurality of second-type wirings, a cross-sectional area of the first-type wiring is smaller than a cross-sectional area of the second-type wiring, and a wiring spacing of the plurality of first-type wirings is smaller than a wiring spacing of the plurality of second-type wirings; the first-type wiring is connected with the second-type wiring, and the first-type wiring or the second-type wiring is connected with the bonding part. The wiring structure includes a plurality of first-type wirings and a plurality of second-type wirings with different cross-sectional areas and different values of wiring spacing, and can be adapted to the transmission of electrical signals with different frequencies and intensities.

In an optional embodiment, the wiring layer includes a plurality of first-type wirings and a plurality of second-type wirings, a cross-sectional area of the first-type wiring is smaller than a cross-sectional area of the second-type wiring, and a wiring spacing of the plurality of first-type wirings is smaller than a wiring spacing of the plurality of second-type wirings; the first-type wiring and the second-type wiring are connected with different bonding parts, respectively.

In an optional embodiment, the first chip includes a first channel layer and a first wiring layer connected with the first channel layer, and the second chip includes a second channel layer and a second wiring layer connected with the second channel layer; the first wiring layer and the second wiring layer are connected with different bonding parts, respectively.

In an optional embodiment, the first wiring layer includes a first signal wiring and a first power wiring, and the first power wiring includes an embedded power line and a through via wiring connected with the embedded power line; the through via wiring penetrates through the first channel layer and is connected with the bonding part. The embedded power line is a metal line structure embedded under a transistor, partly in a silicon substrate and partly in a shallow trench isolation oxide, which can decrease a height of a unit of the first wiring layer and/or the second wiring layer and reduce the voltage drop.

In an optional embodiment, the chip assembly further includes a third chip; the third chip includes a third channel layer and a third wiring layer connected with the third channel layer; the third wiring layer is connected with the first signal wiring. By connecting the third wiring layer of the third chip to the first signal wiring, electrical signals can be transmitted to the third chip directly through the first signal wiring, thereby reducing the voltage drop during the transmission of the electrical signals to the third chip.

In an optional embodiment, the chip assembly further includes a blank die; the first chip and the second chip are disposed on a same side of the chip interposer, and the blank die is disposed between the first chip and the second chip. Through disposing the blank die between the first chip and the second chip, the blank die can absorb the stress between the first chip and the second chip caused by thermal expansion and contraction or external force, thereby improving the reliability of the chip assembly.

In a second aspect, the present disclosure provides a chip interposer, including: a body part and a wiring structure disposed on the body part; the body part includes a cavity and an opening which is connected with the cavity and penetrates through a surface of the body part; the wiring structure includes a wiring layer and a plurality of bonding parts connected with the wiring layer; the wiring layer is disposed in the cavity, and the plurality of bonding parts are exposed from the surface of the body part through the opening.

In an optional embodiment, the wiring layer includes a plurality of first-type wirings and a plurality of second-type wirings, a cross-sectional area of the first-type wiring is smaller than a cross-sectional area of the second-type wiring, and a wiring spacing of the plurality of first-type wirings is smaller than a wiring spacing of the plurality of second-type wirings; the first-type wiring is connected with the second-type wiring, and the first-type wiring or the second-type wiring is connected with the bonding part.

In an optional embodiment, the wiring layer includes a plurality of first-type wirings and a plurality of second-type wirings, a cross-sectional area of the first-type wiring is smaller than a cross-sectional area of the second-type wiring, and a wiring spacing of the plurality of first-type wirings is smaller than a wiring spacing of the plurality of second-type wirings; the first-type wiring and the second-type wiring are connected with different bonding parts, respectively.

In a third aspect, the present disclosure provides a fabricating method for a chip assembly, including: providing a base substrate; forming a chip interposer including a wiring structure on the base substrate, wherein the wiring structure is configured to be connected with an external wiring; and forming a first chip and a second chip connected with the wiring structure on the chip interposer, respectively.

In an optional embodiment, forming the chip interposer including the wiring structure on the base substrate includes: forming a first body layer having an opening on the base substrate; forming a bonding part and a wiring layer on the first body layer; and forming a second body layer on the bonding part and the wiring layer.

In an optional embodiment, forming the first chip and the second chip connected with the wiring structure on the chip interposer respectively includes: transferring the first chip that has been fabricated onto the chip interposer, and bonding a first wiring layer of the first chip to the bonding part; transferring the second chip that has been fabricated onto the chip interposer, and bonding a second wiring layer of the second chip to the bonding part.

In an optional embodiment, bonding the first wiring layer of the first chip to the bonding part includes: bonding a through via wiring of the first wiring layer to the bonding part.

In an optional embodiment, the fabricating method for the chip assembly further includes: removing the base substrate; and forming an encapsulation layer surrounding the first chip, the second chip and the chip interposer.

In an optional embodiment, before removing the base substrate, the fabricating method for the chip assembly further includes: forming a third chip on the first chip, and bonding a third wiring layer of the third chip to a first signal wiring of the first chip.

In an optional embodiment, before the removing the base substrate, the fabricating method for the chip assembly further includes: forming a blank die between the first chip and the second chip.

### BRIEF DESCRIPTION OF THE DRAWINGS

In order to more clearly illustrate the technical solutions of the embodiments of the present disclosure, the drawings of the embodiments will be briefly described in the following. It is obvious that the described drawings are only related to some embodiments of the present disclosure and thus are not intended to limit the present disclosure. For those ordinary skilled in the art, other related drawings can be obtained according to these drawings without creative work.
FIG. 1 is a schematic structural diagram of a 3D-packaged chip assembly;
FIG. 2 is a schematic structural diagram of a chip assembly provided by a first embodiment of the present disclosure;
FIG. 3 is a schematic structural diagram of a chip interposer in the chip assembly provided by the first embodiment of the present disclosure;
FIG. 4 is a schematic structural diagram of a chip assembly provided by another embodiment of the present disclosure;
FIG. 5 is a schematic structural diagram of a chip assembly provided by a second embodiment of the present disclosure;
FIG. 6 is a flow chart illustrating a fabricating method for a chip assembly provided by a third embodiment of the present disclosure;
FIG. 7 to FIG. 12 are schematic diagrams of intermediate structures in various steps of the fabricating method for the chip assembly provided by the third embodiment of the present disclosure;
FIG. 13 is a flow chart of a fabricating method for a chip assembly provided by a fourth embodiment of the present disclosure; and
FIG. 14 is a schematic diagram of an intermediate structure in the fabricating method for the chip assembly provided by the fourth embodiment of the present disclosure.

### DETAILED DESCRIPTION

In order to make objects, technical solutions and advantages of the embodiments of the present disclosure apparent, the technical solutions of the embodiments will be described in a clearly and fully understandable way in connection with the drawings related to the embodiments of the present disclosure. Apparently, the described embodiments are just a part but not all of the embodiments of the present disclosure. Generally, components in embodiments of the present disclosure described and illustrated in the drawings herein may be arranged and designed in various different configurations.

Therefore, the following detailed description of the embodiments of the present disclosure provided in the accompanying drawings is not intended to limit the scope of the claimed disclosure, but merely represents selected embodiments of the present disclosure. Based on the embodiments in the present disclosure, all other embodiments obtained by those ordinary skilled in the art without creative work belong to the scope of protection of the present disclosure.

It should be noted that similar reference numerals and letters indicate similar features in the following drawings. Therefore, once a feature is defined in one drawing, it does not need to be further defined and explained in subsequent drawings.

It should be noted that in the description of the present disclosure, if an orientation or positional relationship indicated by terms "upper", "lower", "inner" and "outer" is based on an orientation or positional relationship shown in the accompanying drawings, or is an orientation or positional relationship that a product is usually placed in use, it is only for the convenience of explaining the present disclosure and simplifying the description, and does not indicate or imply that a device or element referred to must have a specific orientation or must be constructed and operated in a specific orientation, and thus can not be understood as a limitation of the present disclosure.

Additionally, if terms "first" and "second" appear, they are only used for distinguishing descriptions and should not be understood as indicating or implying relative importance.

It should be noted that features in the embodiments of the present disclosure can be combined with each other without conflict.

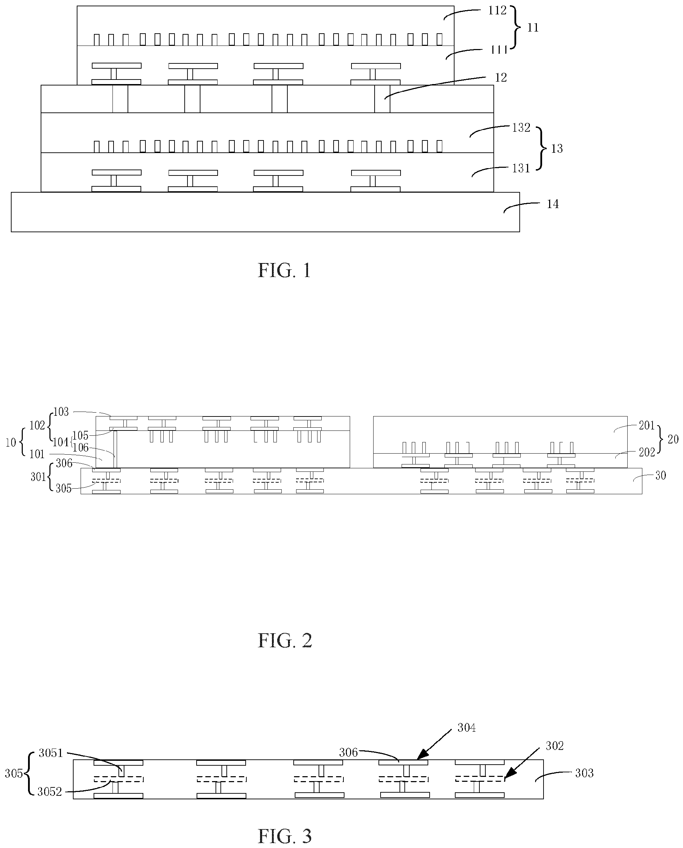

FIG. 1 is a schematic structural diagram of a 3D-packaged chip assembly. As shown in FIG. 1, in the 3D-packaged chip assembly, a charge coupled device (CCD) chip 11 and an SRAM chip 13 are connected through a TSV structure 12, and are finally packaged at an outer side thereof (only a partial structure in which an encapsulation layer 14 encapsulates a surface at a side of the CCD chip is shown in FIG. 1). The CCD chip 11 includes a wiring layer 111 and a channel layer 112; likewise, the SRAM chip 13 includes a wiring layer 131 and a channel layer 132. In the chip assembly shown in FIG. 1, an external power wiring is usually connected to the encapsulation layer 14, and a power energy is transmitted into the CCD chip 11 and the SRAM chip 13 through the encapsulation layer 14. The power energy provided by the power wiring needs to continuously transmit through the wiring layer 111 and the channel layer 112 of the CCD chip 11, the TSV structure 12, and the wiring layer 131 of the SRAM chip 13, so as to be transmitted to the channel layer 132 of the SRAM chip 13. A large voltage drop will be generated during this process, resulting in a relatively low actual voltage of the channel layer 132 of the SRAM chip 13. Moreover, since the CCD chip 11 is connected to the SRAM chip 13 through the TSV structure 12, a wiring density of the TSV structure is limited, which leads to a lower interactive bandwidth between the CCD chip 11 and the SRAM chip 13.

A first embodiment of the present disclosure provides a chip assembly. As shown in FIG. 2, the chip assembly includes a first chip 10, a second chip 20 and a chip interposer 30; the chip interposer 30 is connected with the first chip 10 and the second chip 20, respectively. The chip interposer 30 includes a wiring structure 301 connected with the first chip 10 and the second chip 20, respectively; and the wiring structures 301 may further be configured to be connected to an external wiring. The external wiring may be, for example, a power wiring, and the wiring structure 301 is connected with the power wiring which supplies power to the chip assembly through the wiring structure 301; alternatively, the external wiring may also be an external signal wiring, and the wiring structure 301 is connected with the signal wiring which transmits signal to the chip assembly through the wiring structure 301. It should be understood that the aforementioned external wiring being a power wiring or a signal wiring is only an illustrative example of the external wiring to which the wiring structure 301 may be connected in some embodiments of the present disclosure.

Referring to FIG. 2, in the chip assembly provided in the first embodiment of the present disclosure, taken the external wiring being a power wiring as an example; when the power wiring supplies power to the chip assembly, the current flows into the wiring structure 301 firstly, and then flows into the first chip 10 and the second chip 20 through the wiring structure 301. Compared with the current transmission through the TSV structure shown in FIG. 1, the current transmission in the chip assembly provided in the first embodiment of the present disclosure has shorter transmission path and lower voltage drop. Moreover, since it no longer needs to transmit the current through the TSV structure, the voltage drop during the current transmission can be further reduced.

Additionally, when a signal interaction occurs between the first chip 10 and the second chip 20, the signal sent from the first chip 10 can be transmitted to the second chip 20 through the wiring structure 301, and the signal sent from the second chip 20 can also be transmitted to the first chip 10 through the wiring structure 301. As the signal transmission in the wiring structure 301 is conducted through the wiring structure, and the wiring density of the wiring structure is higher than that of the case where the signal transmission is conducted through the TSV structure, as a result, the signal interaction between the first chip 10 and the second chip 20 has larger bandwidth and higher efficiency.

In the chip assembly provided by the first embodiment of the present disclosure, a wiring structure 301 is disposed to be connected with the first chip 10 and the second chip 20, respectively; meanwhile, since an external wiring is connected with the wiring structure 301, the external wiring can directly supply power to the first chip 10 and the second chip 20 through the wiring structure when supplying power to the chips, so that the voltage drop generated on a path of power supply is small, thereby reducing the voltage drop in the chip assembly; moreover, both the first chip 10 and the second chip 20 are connected with the wiring structure 301, and the first chip 10 and the second chip 20 can be in communication with each other through the wiring structure 301, thereby increasing a bandwidth of signal-interactive communication among different chips in the chip assembly.

In some embodiments of the present disclosure, as shown in FIG. 3, the chip interposer 30 includes a body part 303 provided with cavity(s) 302 (the cavity 302 in FIG. 3 has been filled with a wiring layer 305), and the body part 303 includes an opening 304 which is connected with the cavity 302 and penetrates through a surface of the body part 303 (the opening 304 in FIG. 3 has been filled with a bonding part 306). The wiring structure 301 includes a wiring layer 305 and a plurality of bonding parts 306 connected with the wiring layer 305. The wiring layer 305 is disposed in the cavity 302, and the bonding part 306 is exposed from the surface of the body part 303 through the opening 304. The bonding part 306 is disposed to be exposed from the surface of the body part 303 through the opening 304, so that the bonding part 306 can be utilized to be bonded with other structures, thereby improving the electrical performance of the wiring structure 301 after being connected with other structures.

In some embodiments of the present disclosure, the bonding part 306 may be a pillar structure formed of a conductive material, one end of the pillar structure is connected with the wiring layer 305, the other end of the pillar structure is exposed from the surface of the body part 303 through the opening 304, and a surface of the end exposed from the body part 303 may be connected with the first chip 10 and the second chip 20, thereby realizing the electrical connection between the first chip 10, the second chip 20 and the wiring layer 305. It should be understood that the foregoing is only an example of the specific structure of the bonding part 306 in some embodiments of the present disclosure. In some other embodiments of the present disclosure, the bonding part 306 may also be a plate-shaped structure or a line-shaped structure with one side connected to the wiring layer 305 and the other side connected to the first chip 10 and the second chip 20, which can be flexibly disposed according to actual needs.

Further, in some embodiments of the present disclosure, as shown in FIG. 3, the wiring layer 305 includes a plurality of first-type wirings 3051 and a plurality of second-type wirings 3052. A cross-sectional area of the first-type wiring 3051 is smaller than that of the second-type wiring 3052. For example, the first-type wiring 3051 may be configured as a fine wiring with a thickness of 0.8 micron and a width of 0.4 micron, and the second-type wiring 3052 may be a thick copper wiring with a thickness of 1 micron and a width of 2 microns, for example. Through disposing the first-type wirings 3051 and the second-type wirings 3052 with different cross-sectional areas, it can be applied to the transmission of electrical signals with different frequencies and intensities. For example, the first-type wiring 3051 with smaller cross-sectional area can be configured to transmit data signal current with smaller current, while the second-type wiring 3052 with larger cross-sectional area can be configured to transmit power supply current with larger current. Additionally, in some embodiments of the present disclosure, according to the actual needs of current transmission, a wiring spacing of the plurality of first-type wirings 3051 may further disposed to be smaller than a wiring spacing of the plurality of second-type wirings 3052; for example, the wiring spacing between the plurality of first-type wirings 3051 may be set to be 0.4 micron, and the wiring spacing between the plurality of second-type wirings 3052 may be set to be 1 micron, etc.; alternatively, the cross-sectional area of the first-type wiring 3051 is set to be smaller than the cross-sectional area of the second-type wiring 3052, and the wiring spacing of the plurality of first-type wirings 3051 is set to be smaller than the wiring spacing of the plurality of second-type wirings 3052, which can be specifically set according to actual needs. The wiring structure 301 includes a plurality of first-type wirings 3051 and a plurality of second-type wirings 3052 with different cross-sectional areas and different values of wiring spacing, so as to be adapted to the transmission of electrical signals with different frequencies and intensities.

In different embodiments of the present disclosure, the first-type wiring 3051 and the second-type wiring 3052 are connected with the bonding part 306 in different connecting modes. FIG. 3 is an example illustrating a specific connecting mode of the first-type wiring 3051 and the second-type wiring 3052 connecting with the bonding part 306 in an embodiment of the present disclosure, in which the first-type wiring 3051 and the second-type wiring 3052 are connected with each other, and the first-type wiring 3051 is connected with the bonding part 306. It should be understood that the connection between the first-type wiring 3051 and the bonding part 306 is only a particular illustration shown in FIG. 3, and is not intended to constitute any limitation. In some other embodiments of the present disclosure, it's also possible that the second-type wiring 3052 is connected with the bonding part 306, or, the first-type wiring 3051 and the second-type wiring 3052 may be insulated from each other and connected with different bonding parts 306 respectively, which can be particularly set according to actual needs.

Specifically, as shown in FIG. 2, the first chip 10 includes a first channel layer 101 and a first wiring layer 102 connected to the first channel layer 101, and the second chip 20 includes a second channel layer 201 and a second wiring layer 202 connected to the second channel layer 201. The first wiring layer 102 and the second wiring layer 202 are connected to different bonding parts 306, respectively. In some embodiments of the present disclosure, the first wiring layer 102 and the bonding parts 306 may be connected by bonding through means of hybrid bonding technology. The hybrid bonding technology is different from the traditional bump soldering technology in that the hybrid bonding technology involves no protruded bumps; instead, specially fabricated dielectric has a smooth surface and actually further has a slight recess. Two dielectrics are attached with each other at a room temperature, and then are annealed by raising the temperature; at this time, the dielectrics will be expanded and firmly bonded together, thus forming an electrical connection. The hybrid bonding technology can reduce the connection spacing to be less than 10 microns, so as to obtain higher current carrying capacity and tighter interconnection density between dielectrics, and achieve better thermal performance as compared with underfill.

Further, in some embodiments of the present disclosure, as shown in FIG. 2, the first wiring layer 102 includes a first signal wiring 103 and a first power wiring 104, and the first power wiring 104 includes an embedded power line 105 and a through via wiring 106 connected to the embedded power line 105. The through via wiring 106 penetrates through the first channel layer 101, and the through via wiring 106 is connected with the bonding part 306. The embedded power line 105 is a metal line structure embedded under a transistor, partly in a silicon substrate and partly in a shallow trench isolation oxide, which can decrease a height of the first wiring layer 102 and reduce the voltage drop.

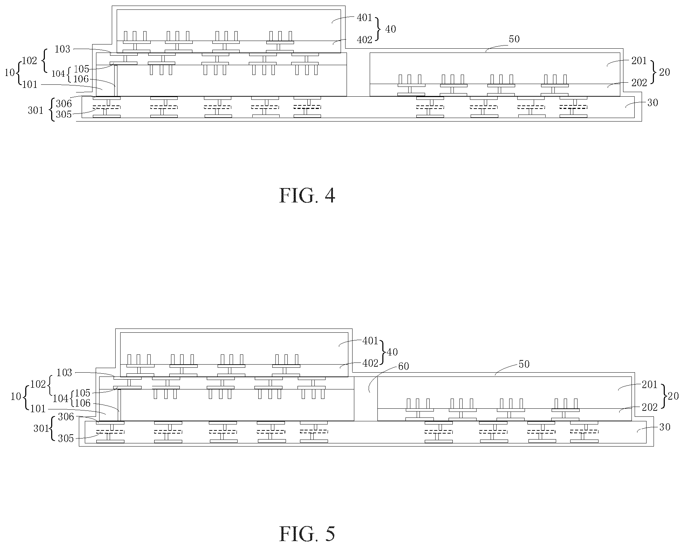

Further, as shown in FIG. 4, in some embodiments of the present disclosure, the chip assembly may further include a third chip 40. The third chip 40 includes a third channel layer 401 and a third wiring layer 402 connected with the third channel layer 401. The third wiring layer 402 is connected with the first signal wiring 103. By connecting the third wiring layer 402 of the third chip 40 to the first signal wiring 103, electrical signals can be transmitted to the third chip 40 directly through the first signal wiring 103, thereby reducing the voltage drop during the transmission of the electrical signals to the third chip 40.

Moreover, as shown in FIG. 4, in some embodiments of the present disclosure, the chip assembly may further include an encapsulation layer 50 surrounding the first chip 10, the second chip 20, the third chip 40 and the chip interposer 30, and an interface for connecting to the external wiring may be provided on the encapsulation layer 50.

A second embodiment of the present disclosure provides a chip assembly. As shown in FIG. 5, similar to the chip assembly provided in the first embodiment, the chip assembly provided in the second embodiment of the present disclosure also includes a first chip 10, a second chip 20, a chip interposer 30 and an encapsulation layer 50 disposed to surround the first chip 10, the second chip 20 and the chip interposer 30, the difference lies in that the chip assembly provided in the second embodiment of the present disclosure further includes a blank die 60. The first chip 10 and the second chip 20 are disposed on the same side of the chip interposer 30, and the blank die 60 is disposed between the first chip 10 and the second chip 20.

The chip assembly provided in the second embodiment of the present disclosure also includes the first chip 10, the second chip 20, the chip interposer 30 and the encapsulation layer 50 disposed to surround the first chip 10, the second chip 20 and the chip interposer 30, and thus achieves the same technical effects as those described in the first embodiment. Moreover, a blank die 60 is disposed between the first chip 10 and the second chip 20 in the chip assembly provided by the second embodiment of the present disclosure, and the blank die 60 can absorb a stress between the first chip 10 and the second chip 20 generated due to thermal expansion and contraction or external force, thereby improving the reliability of the chip assembly.

Further, in some embodiments of the present disclosure, the blank die 60, the first chip 10 and the second chip 20 have the same thickness. Setting the abovementioned three components to have the same thickness can facilitate the subsequent planarization and encapsulating processes being performed in a better way and improve the overall reliability of the chip assembly.

An embodiment of the present disclosure further provides a chip interposer, the specific structure and function of the chip interposer are basically the same as those of the chip interposer 30 in the aforementioned embodiments of chip assembly. For details, reference can be made to the specific description in the aforementioned embodiments, which will not be repeated here.

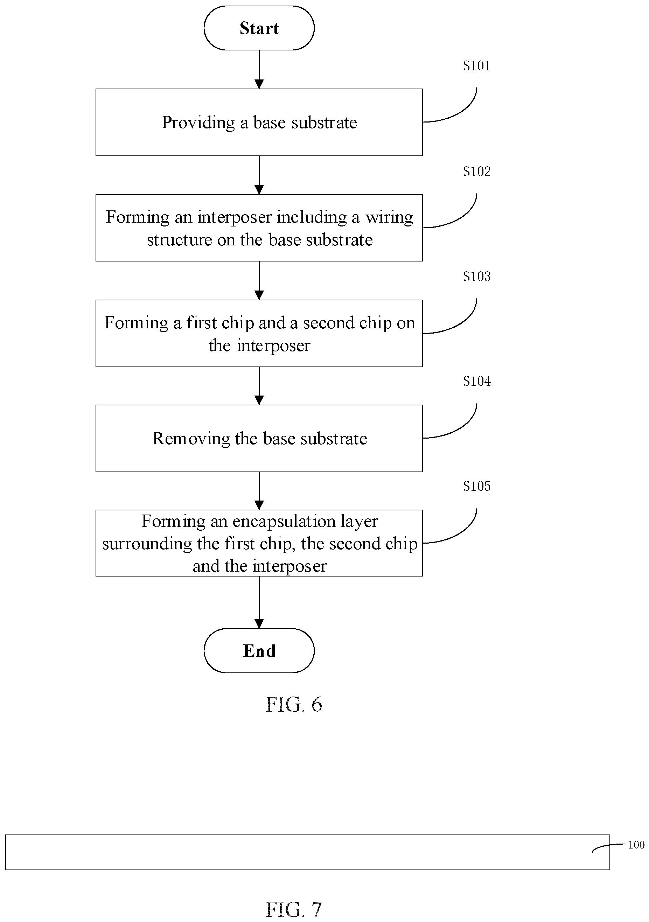

A third embodiment of the present disclosure provides a fabricating method for a chip assembly. Specifically, as shown in FIG. 6, the fabricating method includes the following steps.

Step S101: providing a base substrate.

Specifically, as shown in FIG. 7, the base substrate 100 may be a silicon substrate, for example. It should be understood that the base substrate 100 made of silicon is only an example in some embodiments of the present disclosure, and is not intended to constitute any limitation.

Step S102: forming a chip interposer including a wiring structure on the base substrate.

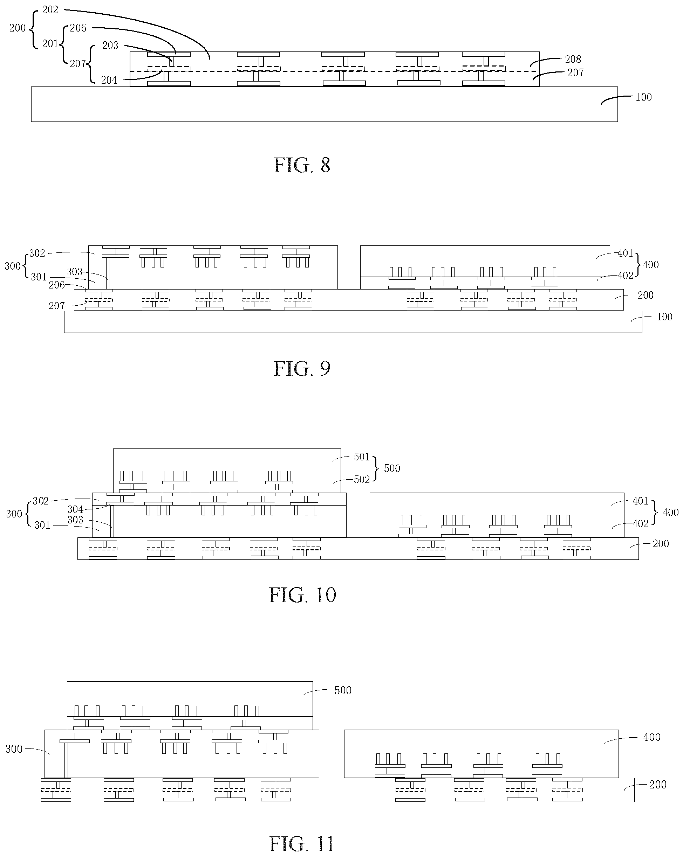

Specifically, as shown in FIG. 8, a chip interposer 200 is fabricated and formed on the base substrate 100. The chip interposer 200 includes a wiring structure 201 and a body part 202, and the wiring structure 201 may include first-type wirings 203 and second-type wirings 204. For details of the wiring structure 201 and the body part 202, reference can be made to the specific description in the foregoing embodiments, which will not be repeated here.

In some embodiments of the present disclosure, as shown in FIG. 8, the chip interposer 200 may be directly fabricated and formed on the base substrate 100. For example, firstly, a first body layer 205 provided with an opening is fabricated on the base substrate 100; and then a wiring structure 201 including a bonding part 206 and a wiring layer 207 is fabricated on the first body layer 205; finally, a second body layer 208 is fabricated on the wiring structure 201 so as to form a complete chip interposer 200. Alternatively, the chip interposer 200 may be formed on other tools and then transferred onto the base substrate 100; or a part of the chip interposer including the first-type wirings 203 and a part of the chip interposer including the second-type wirings 204 may be formed on other tools, and then transferred onto the base substrate 100 and spliced together to form the chip interposer 200. specifically, it may be fabricated according to actual needs.

Step S103: forming a first chip and a second chip on the chip interposer.

Specifically, as shown in FIG. 9, a first chip 300 includes a first channel layer 301 and a first wiring layer 302, and a second chip 400 includes a second channel layer 401 and a second wiring layer 402. In different embodiments of the present disclosure, the first chip 300 and the second chip 400 may be sequentially fabricated on the chip interposer 200, that is to say, the first chip 300 is fabricated on the chip interposer 200 firstly and then the second chip 400 is fabricated on the chip interposer 200, or the first chip 300 and the second chip 400 may be simultaneously fabricated on the chip interposer 200. It is also possible to form the first chip 300 and the second chip 400 on other tools, and then transfer the fabricated first chip 300 and the fabricated second chip 400 onto the chip interposer 200, and then bond the first wiring layer 302 and the second wiring layer 402 to the bonding part 206 respectively, which can be flexibly set according to actual needs. In some embodiments of the present disclosure, for example, the hybrid bonding technology can be used for the bonding. The hybrid bonding technology is different from the traditional bump soldering technology in that the hybrid bonding technology involves no protruded bumps; instead, the specially fabricated dielectric has a smooth surface. In this embodiment, that is to say, the first wiring layer 302 and the bonding part 206 have smooth surfaces, which actually have a slight recess. The first wiring layer 302 and the bonding part 206 are attached with each other at a room temperature, and then annealed by raising the temperature; at this time, the first wiring layer 302 and the bonding part 206 will be expanded and firmly bonded together, thus forming an electrical connection. The hybrid bonding technology can reduce the connection spacing to be less than 10 microns, so as to obtain higher current carrying capacity and tighter density of interconnected dielectrics, and achieve better thermal performance as compared with underfill.

Specifically, in some embodiments of the present disclosure, bonding the first wiring layer 302 with the bonding part 206 may be bonding a through via wiring 303 in the first wiring layer 302 to the bonding part 206. For specific structure, reference can be made to the detailed description in the previous embodiments, and will not be repeated here.

Further, in some embodiments of the present disclosure, the first chip 300 and the second chip 400 may further be planarized, that is to say, a planarization process is performed on sides of the first chip 300 and the second chip 400 away from the chip interposer 200.

Further, in some embodiments of the present disclosure, as shown in FIG. 10, in addition to the first chip 300 and the second chip 400, a third chip 500 may further be fabricated on the first chip 300, and the third chip 500 includes a third channel layer 501 and a third wiring layer 502, and the third wiring layer 502 is connected with the first chip 300. Specifically, the third wiring layer 502 may be bonded to a first signal wiring 304 of the first chip 300. It should be understood that, the additional fabrication of the third chip 500 on the first chip 300 is only an exemplary illustration in some embodiments of the present disclosure, and is not intended to constitute any limitation. In some other embodiments of the present disclosure, other structures such as a fourth chip and a fifth chip may be included, which may be particularly set according to actual needs.

Step S104: removing the base substrate.

In this step, as shown in FIG. 11, after formation of each of the chips in the chip assembly is completed, the base substrate can be removed by a process such as etching or the like.

Step S105: forming an encapsulation layer surrounding the first chip, the second chip and the chip interposer.

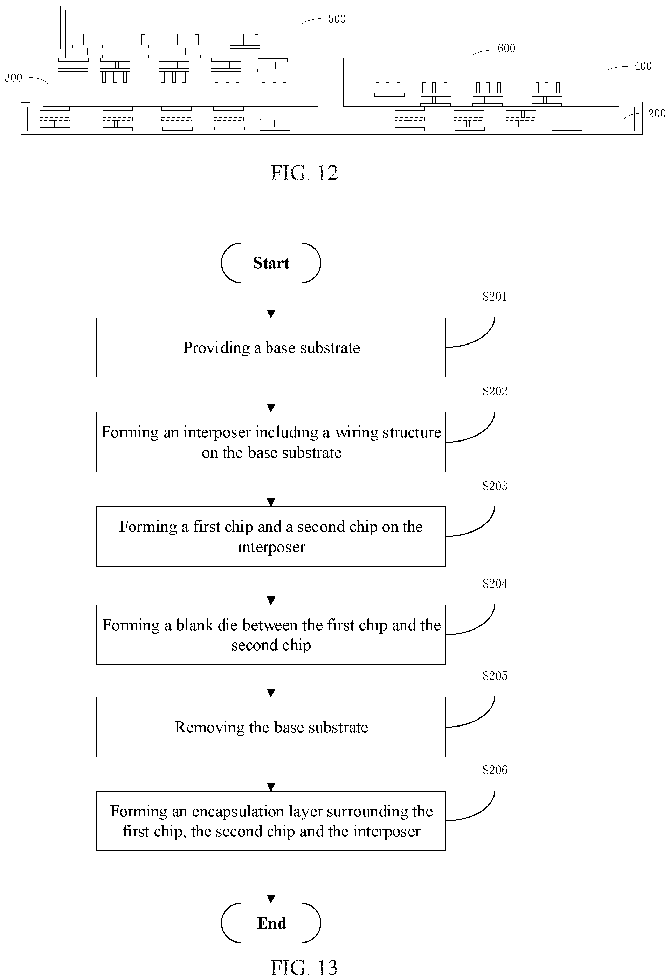

In this step, as shown in FIG. 12, the chip assembly with the base substrate 100 removed can be assembled with the encapsulation layer 600 for packaging. It should be understood that the structure of the encapsulation layer 600 shown in FIG. 11 is only an exemplary illustration in some embodiments of the present disclosure. In some other embodiments of the present disclosure, the encapsulation layer 600 may also include other encapsulation structures, such as an encapsulation layer with closed space surrounding the first chip, the second chip, and the chip interposer.

In the fabricating method for the chip assembly provided by the third embodiment of the present disclosure, the wiring structure 201 is formed in the chip interposer 200 and disposed to be connected with the first chip 300 and the second chip 400 respectively; meanwhile, since the external wiring is connected with the wiring structure 201, the external wiring can directly supply power to the first chip 300 and the second chip 400 through the wiring structure 201 when supplying power to the chip assembly, so that a smaller voltage drop is generated on the path of power supply, thereby reducing the voltage drop in the chip assembly. Moreover, both the first chip 300 and the second chip 400 are connected with the wiring structure 201, and the first chip 300 and the second chip 400 can be in communication with each other through the wiring structure in the wiring structure 201, thereby improving the bandwidth of signal-interactive communication among different chips in the chip assembly.

A fourth embodiment of the present disclosure provides a fabricating method for a chip assembly. As specifically shown in FIG. 13, the fabricating method includes the following steps.

Step S201: providing a base substrate.

Step S202: forming a chip interposer including a wiring structure on the base substrate.

Step S203: forming a first chip and a second chip on the chip interposer.

Step S204: forming a blank die between the first chip and the second chip.

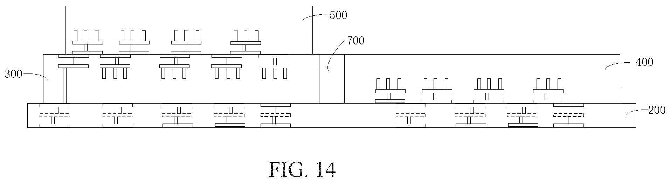

In this step, as shown in FIG. 14, a blank die 700 is formed between the first chip 300 and the second chip 400. The blank die 700 is a die that has not been patterned or activated, and mainly plays a role in absorbing a stress between other chips such as the first chip 300 and the second chip 400 due to thermal expansion and contraction or distortion and deformation, and improving the heat dissipation efficiency of other chips such as the first chip 300 and the second chip 400.

Step S205: removing the base substrate.

Step S206: forming an encapsulation layer surrounding the first chip, the second chip and the chip interposer.

It should be understood that, steps S201 to S203 and steps S205 and S206 in the fourth embodiment of the present disclosure are substantially the same as steps S101 to S105 in the foregoing third embodiment. For details, reference can be made to the particular descriptions in the previous embodiments, which will not be repeated here.

The fabricating method for the chip assembly provided by the fourth embodiment of the present disclosure retains the technical effects of the third embodiment; and meanwhile, by disposing a blank die 700 between the first chip 300 and the second chip 400, the blank die 700 can absorb the stress between the first chip 300 and the second chip 400 caused by thermal expansion and contraction or external force, thereby improving the reliability of the chip assembly.

The above are merely specific embodiments of the present disclosure, but the scope of protection of the present disclosure is not limited thereto. Any change or replacement that can be easily conceived of by an ordinary skilled familiar with the technical field within the technical scope revealed in the present disclosure should be fallen into the scope of protection of the present disclosure. Therefore, the scope of protection of the present disclosure should be determined by the scope of protection of the claims.

## Claims

1. A chip assembly, comprising:
a first chip;
a second chip; and
a chip interposer, connected with the first chip and the second chip, respectively,
wherein the chip interposer comprises a wiring structure configured to be connected to an external wiring, and
the wiring structure is connected with the first chip and the second chip, respectively.

2. The chip assembly according to claim 1, wherein the chip interposer further comprises a body part having a cavity, and the body part comprises an opening which is connected with the cavity and penetrates through a surface of the body part;
the wiring structure comprises a wiring layer and a plurality of bonding parts connected with the wiring layer;
the wiring layer is disposed in the cavity, and the plurality of bonding parts are exposed from the surface of the body part through the opening.

3. The chip assembly according to claim 2, wherein the wiring layer comprises a plurality of first-type wirings and a plurality of second-type wirings, a cross-sectional area of a first-type wiring of the plurality of first-type wirings is smaller than a cross-sectional area of a second-type wiring of the plurality of second-type wirings, and a wiring spacing of the plurality of first-type wirings is smaller than a wiring spacing of the plurality of second-type wirings;
the first-type wiring is connected with the second-type wiring, and the first-type wiring or the second-type wiring is connected with a bonding part of the plurality of the bonding parts.

4. The chip assembly according to claim 2, wherein the wiring layer comprises a plurality of first-type wirings and a plurality of second-type wirings, a cross-sectional area of a first-type wiring of the plurality of first-type wirings is smaller than a cross-sectional area of a second-type wiring of the plurality of first-type wirings, and a wiring spacing of the plurality of first-type wirings is smaller than a wiring spacing of the plurality of second-type wirings;
the first-type wiring and the second-type wiring are connected with different bonding parts of the plurality of bonding parts, respectively.

5. The chip assembly according to any one of claims 2-4, wherein the first chip comprises a first channel layer and a first wiring layer connected with the first channel layer, and the second chip comprises a second channel layer and a second wiring layer connected with the second channel layer;
the first wiring layer and the second wiring layer are connected with different bonding parts of the plurality of bonding parts, respectively.

6. The chip assembly according to claim 5, wherein the first wiring layer comprises a first signal wiring and a first power wiring, and the first power wiring comprises an embedded power line and a through via wiring connected with the embedded power line;
the through via wiring penetrates through the first channel layer and is connected with the bonding part.

7. The chip assembly according to claim 6, further comprising a third chip;
wherein the third chip comprises a third channel layer and a third wiring layer connected with the third channel layer;
the third wiring layer is connected with the first signal wiring.

8. The chip assembly according to any one of claims 1-7, further comprising a blank die;
wherein the first chip and the second chip are disposed on a same side of the chip interposer, and the blank die is disposed between the first chip and the second chip.

9. A chip interposer, comprising:
a body part and a wiring structure disposed on the body part; wherein
the body part comprises a cavity and an opening which is connected with the cavity and penetrates through a surface of the body part;
the wiring structure comprises a wiring layer and a plurality of bonding parts connected with the wiring layer;
the wiring layer is disposed in the cavity, and the plurality of bonding parts are exposed from the surface of the body part through the opening.

10. The chip interposer according to claim 9, wherein the wiring layer comprises a plurality of first-type wirings and a plurality of second-type wirings, a cross-sectional area of a first-type wiring of the plurality of first-type wirings is smaller than a cross-sectional area of a second-type wiring of the plurality of second-type wirings, and a wiring spacing of the plurality of first-type wirings is smaller than a wiring spacing of the plurality of second-type wirings;
the first-type wiring is connected with the second-type wiring, and the first-type wiring or the second-type wiring is connected with a bonding part of the plurality of bonding parts.

11. The chip interposer according to claim 9, wherein the wiring layer comprises a plurality of first-type wirings and a plurality of second-type wirings, a cross-sectional area of a first-type wiring of the plurality of first-type wirings is smaller than a cross-sectional area of a second-type wiring of the plurality of second-type wirings, and a wiring spacing of the plurality of first-type wirings is smaller than a wiring spacing of the plurality of second-type wirings;
the first-type wiring and the second-type wiring are connected with different bonding parts of the plurality of bonding parts, respectively.

12. A fabricating method for a chip assembly, comprising:
providing a base substrate;
forming a chip interposer comprising a wiring structure on the base substrate, wherein the wiring structure is configured to be connected with an external wiring; and
forming a first chip and a second chip connected with the wiring structure on the chip interposer, respectively.

13. The fabricating method for the chip assembly according to claim 12, wherein the forming the chip interposer comprising the wiring structure on the base substrate comprises:
forming a first body layer having an opening on the base substrate;
forming a bonding part and a wiring layer on the first body layer; and
forming a second body layer on the bonding part and the wiring layer.

14. The fabricating method for the chip assembly according to claim 13, wherein the forming the first chip and the second chip connected with the wiring structure on the chip interposer respectively comprises:
transferring the first chip that has been fabricated onto the chip interposer, and bonding a first wiring layer of the first chip to the bonding part;
transferring the second chip that has been fabricated onto the chip interposer, and bonding a second wiring layer of the second chip to the bonding part.

15. The fabricating method for the chip assembly according to claim 14, wherein bonding the first wiring layer of the first chip to the bonding part comprises:
bonding a through via wiring of the first wiring layer to the bonding part.

16. The fabricating method for the chip assembly according to claim 15, further comprising:
removing the base substrate; and
forming an encapsulation layer surrounding the first chip, the second chip and the chip interposer.

17. The fabricating method for the chip assembly according to claim 16, wherein before the removing the base substrate, the fabricating method for the chip assembly further comprises:
forming a third chip on the first chip, and bonding a third wiring layer of the third chip to a first signal wiring of the first chip.

18. The fabricating method for the chip assembly according to claim 16 or 17, wherein before the removing the base substrate, the fabricating method for the chip assembly further comprises:
forming a blank die between the first chip and the second chip.
